(19) 

**Europäisches Patentamt**
**European Patent Office**
**Office européen des brevets**

(11)  **EP 3 467 150 B1**

(12) **EUROPEAN PATENT SPECIFICATION**

(45) Date of publication and mention
of the grant of the patent:
**25.10.2023   Bulletin 2023/43**

(21) Application number: **18197148.2**

(22) Date of filing: **27.09.2018**

(51) International Patent Classification (IPC):
**C23C 28/04** *(2006.01)*       **C23C 14/06** *(2006.01)*
**C23C 14/32** *(2006.01)*

(52) Cooperative Patent Classification (CPC):
**C23C 28/044; C23C 14/0641; C23C 14/325**

(54) **HARD COATING FOR CUTTING TOOLS**

HARTBESCHICHTUNG FÜR SCHNEIDWERKZEUGE

REVÊTEMENT DUR POUR OUTILS DE COUPE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.09.2017   JP 2017189804**

(43) Date of publication of application:
**10.04.2019   Bulletin 2019/15**

(73) Proprietor: **UNION TOOL CO.**
**Tokyo (JP)**

(72) Inventors:
• **HIROSE, Keita**
**Shinagawa, Tokyo (JP)**

• **KAWAMURA, Kazuhiro**
**Shinagawa, Tokyo (JP)**

(74) Representative: **Kramer Barske Schmidtchen
Patentanwälte PartG mbB
European Patent Attorneys
Landsberger Strasse 300
80687 München (DE)**

(56) References cited:
**JP-A- H1 025 566       JP-A- 2003 136 305**
**JP-A- 2003 136 306       JP-A- 2003 136 307**
**JP-B2- 4 459 936**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

TECHNICAL FIELD

The present invention relates to a hard coating for a cutting tool to be coated onto an end mill, drill, or other cutting tool.

BACKGROUND ART

There are examples of AlCrN coatings with excellent abrasion resistance as hard coatings for coating metal cutting tools (see Patent Document 1), but there are also known AlCrVBN coatings having greater abrasion resistance than AlCrN due to the addition V and B to AlCrN (see Patent Document 2).

Patent Document 2 furthermore discloses that adding V to CrN improves lubricity. In Patent Document 2, coating a CrVN coating on the surface layer of an AlCrVBN coating is intended to improve seizing resistance (lubricity), but seizing resistance is insufficient when stainless steel is worked and there is a need for further improvement in seizing resistance.

In other words, stainless steel (in particular, SUS304 and other austenitic stainless steels) has high viscosity and machining hardenability, and accordingly, there is need for both hardness and toughness in a coating for a tool for machining. Also, since the thermal conductivity is low, high heat generated during cutting and machining does not readily dissipate, and the tool blade tip readily seizes. Consequently, there is not only a need for abrasion resistance, but also seizing resistance.

When the tool blade tip has seized, machining surface roughness is worsened due to wear between seized material and the material being cut, and when machining is further continued, the seized material is more firmly deposited on the tool blade tip and a "built-up" blade tip is formed. It is known that when cutting and machining is further continued in a state in which a built-up blade tip has been formed, the built-up blade tip repeatedly grows and falls away. In such a case, the tool blade tip becomes chipped when the built-up blade tip falls away, whereby the hard coating falls off. Therefore, not only does this lead to further abrasion and degraded machining surface roughness, but also to reduced service life of the tool.

Owing to the above reasons, a tool covered with a hard coating for machining stainless steel requires not only abrasion resistance, but also seizing resistance so that chipping does not occur due to a built-up blade tip, and as described above, sufficient seizing resistance has currently not yet been obtained with a conventional hard coating.

[Prior Art Documents]

[Patent Documents]

[Patent Document 1] Japanese Patent Application Laid-open No. H10-25566
[Patent Document 2] Japanese Patent No. 4459936

JP 2003 136305 A discloses a surface coated cemented carbide cutting tool having hard coating layer exerting excellent ware resistance in high-speed cutting.

JP 2003 136306 A discloses a similar cutting tool.

The same applies to JP 2003 136307 A.

DISCLOSURE OF THE INVENTION

**Problem the Invention is to Solve**

In view of the above-described current situation, an object of the present invention is to provide an extremely practical hard coating for a cutting tool that is a further improvement of the hard coating according to Patent Document 2, and in which good abrasion resistance and seizing resistance is demonstrated against austenitic stainless steels, and longer service life of a cutting tool is realized.

**Means for Solving the Problem**

The above object is achieved by a cutting tool in accordance with claim 1. Further developments of the invention are recited in the dependent claims.

**Effect of the Invention**

The present invention, being configured as described above, is an extremely practical cutting tool in which excellent abrasion resistance and seizing resistance additionally against austenitic stainless steel are demonstrated, and with which a longer service life of a cutting tool can be realized.

BRIEF DESCRIPTION OF THE DRAWINGS

FIG. 1 is an overall descriptive view of the external periphery abrasion width;
FIG. 2 is an overall descriptive view of the maximum seizing width;
FIG. 3 is an X-ray diffraction pattern of experiment example 2 (measurement range: $0° \leq 2\theta \leq 80°$);
FIG. 4 is an X-ray diffraction pattern of experiment example 10 (measurement range: $0° \leq 2\theta \leq 80°$);
FIG. 5 is an X-ray diffraction pattern of conventional example 2 (measurement range: $0° \leq 20 \leq 80°$); and
FIG. 6 is a comparative view of the X-ray diffraction patterns of experiment 2 and the substrate alone (measurement range: $0° \leq 2\theta \leq 80°$).

BEST MODE FOR CARRYING OUT THE INVENTION

Embodiments of the present invention considered to be advantageous are briefly described with indications the effects of the present invention.

The first coating layer has a predetermined composition and does not include V and B; therefore, hardness is not excessively high, hardness and toughness are both achieved, and good abrasion resistance against stainless steel is demonstrated. Also, seizing resistance can be ensured by the second coating layer, which has excellent lubricity.

Therefore, it is possible to improve the abrasion resistance and seizing resistance of a cutting tool against stainless steel (in particular, austenitic stainless steel), and to inhibit chipping to the extent possible and ensure a longer service life of a cutting tool.

**Examples**

Specific examples of the present disclosure are described with reference to the diagrams.

The present example is a hard coating for a cutting tool that is formed on a substrate, the hard coating for a cutting tool comprising:

a first coating layer consisting of

$$\mathrm{Al}_{(100-x)}\mathrm{Cr}_{(x)}$$

where $25 \leq X \leq 35$
with the metal component content expressed in units of at%,
N as a non-metal element, and inevitable impurities; and

a second coating layer consisting of

$$\mathrm{Cr}_{(100-\alpha)}\mathrm{V}_{(\alpha)}$$

where $15 \leq \alpha \leq 50$
with the metal component content expressed in units of at%,
N as a non-metal element, and inevitable impurities,

the second coating layer being disposed on the topmost surface.

Each part will be described in detail.

The substrate is made of a super hard metal alloy containing WC (tungsten carbide) and Co (cobalt). Specifically, the average particle diameter of the WC particles is set to be 0.1 $\mu$m or more and 2.0 pm or less, and the Co content is set to be 5 mass% or more and 15 mass% or less. The substrate is specifically an end mill, or a drill or other cutting tool, and the first coating layer and the second coating layer are sequentially provided in a layered state on the surface of the cutting tool.

The ratio of the thickness T1 of the first coating layer and the thickness T2 of the second coating layer is set to $0.1 \leq T2/T1 \leq 0.5$, and set so that the sum of the thickness T1 and the thickness T2 will be 2.0 pm or more and 5.0 pm or less.

The present example includes a NaCl crystal structure and the diffraction intensity of the (111) plane measured by X-ray diffractometry is greater than the diffraction intensity of the (200) plane.

Specifically, the following expression holds, where I(111) is the diffraction intensity of the (111) plane and I(200) is the diffraction intensity of the (200) plane.

$$I(111)/I(200) \geq 1.5 \qquad\qquad (1)$$

The term $\alpha$ is preferably set to 15 or more and 25 or less.

In the present example, an undercoat layer is provided between the substrate and the first coating layer. The undercoat layer comprises a Ti nitride or carbonitride, and the thickness of the undercoat layer is set to 0.20 pm or more and 1.0 $\mu$m or less.

In other words, the present example is composed of an undercoat layer disposed directly on the cutting tool, a first coating layer disposed on the undercoat layer, and a second coating layer disposed on the first coating layer.

The reasons for the above-stated configuration and the effects obtained by the configuration are described below.

First, the reasons for the above-described configuration will be stated in terms of the composition and thickness of the first coating layer and the second coating layer.

Stainless steel, which is a hard-to-cut material, has high viscosity and machining hardenability; accordingly, there is need for both hardness and toughness in a tool for machining stainless steel. The AlCrVBN coating of Patent Document 2, in which V and B have been added to an AlCrN coating, has inferior toughness ostensibly because hardness is excessively high, and chipping is observed even in the initial stage of machining when stainless steel is machined (see conventional examples 1 to 3 in Table 1 of the later-described experiment examples). Chipping in the initial stage of machining was not observed in $(Al_{70}Cr_{30})N$ to which V and B have not been added, but abrasion resistance was inferior (Conventional example 4 of Table 1).

In view of the above and as a result of attempts to develop a coating (first coating layer) provided with both chipping resistance and abrasion resistance, and repeated variations of experiments and investigations, it was found that a coating, in which the composition is $(Al_{(100-x)}Cr_{(x)})N$ (where $25 \leq x \leq 35$) and contains a NaCl crystal structure, and the diffraction intensity of the (111) plane measured by X-ray diffractometry is greater than the diffraction intensity of the (200) plane (a coating in which the maximum intensity peak plane index is (111), where the measurement range $0° \leq 2\theta \leq 80°$), does not undergo chipping in the initial stage of machining and has excellent abrasion resistance (Comparative examples 1 to 3 of Table 1). Cases excluded from the above-stated composition undergo considerable abrasion (Comparative examples 4 to 6 of Table 1). Cases in which the maximum intensity peak plane index is not (111) also undergo considerable abrasion (Comparative examples 7 to 9 of Table 1). This is presumably because, when the composition is $(Al_{(100-x)}Cr_{(x)})N$ (where $25 \leq x \leq 35$), the hardness is highest, and the density is high because the closest-packed plane is the (111) plane of a NaCl crystal, which is the structure of AlCrN, and the abrasion resistance and chipping resistance are excellent. On the other hand, seizing resistance is inadequate (Comparative examples 1 to 3 of Table 1).

Machining surface roughness degrades when the tool seizes. When machining is further continued with seizing unresolved, a built-up blade tip is formed, the built-up blade tip repeatedly grows and falls away, and chipping and abrasion are accelerated, leading to shorter tool service life.

The surface of the first coating layer is coated with a second coating layer ($Cr_{(100-\alpha)}V_{(\alpha)}N$ in order to improve the seizing resistance of the first coating layer against stainless steel. A CrN coating is known as a coating having excellent lubricity, and V, which has excellent lubricating performance against steel materials, is dissolved as a solid solution in CrN with the intention of improving lubricity. Coating hardness is reduced when the V content is excessively high, and therefore, the experimentation was carried by varying the V content. It was found that seizing resistance is excellent when the composition is $(Cr_{(100-\alpha)}V_{(\alpha)})N$ (where $15 \leq \alpha \leq 50$) (see Experiment examples 1-18 of Table 2). In other words, when $\alpha < 15$, lubricity is inadequate and seizing increases (Comparative examples 10, 11 of Table 1). Seizing increases when $\alpha > 50$ as well (Comparative example 12 of Table 1). This is presumably because with the V content being excessive, the film becomes soft, the CrVN film is worn away in the initial stage of machining, and the seizing resistance effect disappears.

In view of the above, it was found that when the composition of the second coating layer is $(Cr_{(100-\alpha)}V_{(\alpha)})N$ (where $15 \leq \alpha \leq 50$), a balance between lubricity and hardness can be achieved. In particular, it was found that the effect of $\alpha$ being in the range of $15 \leq \alpha \leq 25$ is considerable (Experiment examples 1 to 5, 8 to 10, and 13 to 18 of Table 2).

The thickness ratio of the thicknesses T1 and T2 is preferably $0.1 \leq T2/T1 \leq 0.5$, where T1 is the thickness of the first coating layer and T2 is the thickness of the second coating layer. When T2/T1 is less than 0.1, the effect of seizing resistance is low (comparative example 13 of Table 1), and when T2/T1 exceeds 0.5, the ratio of the second coating layer with low hardness is increased and abrasion resistance is reduced (Comparative examples 14, 15 of Table 1). The total thickness (T1 + T2) of the first coating layer and the second coating layer is preferably 2.0 pm or more and 5.0 pm or less. When the total thickness is too low, the abrasion resistance effect is reduced (Comparative example 16 of Table 1), and when the thickness is greater than 5.0 pm, the abrasion resistance effect can be maintained (Comparative example 17 of Table 1), but the film formation time is extended in commensurate fashion to the greater thickness. Also, a greater amount of the target material is consumed, resulting in a high-cost cutting tool. It has already been confirmed that the rake face peels away when the total thickness (T1 + T2) exceeds 11 pm.

Next, the reasons for using the above-described configuration in terms of the composition and thickness of the undercoat layer will be described.

It was found that abrasion resistance and seizing resistance are further improved by disposing a compound comprising a Ti nitride or carbonitride as an undercoat layer between the substrate for a cutting tool and the first coating layer, and by optimizing adhesion between the substrate and the first coating layer (Experiment examples 1 to 10, 13 to 18 of Table 2, Experiment examples 19 to 27 of Table 3). It was also found that the thickness of the undercoat layer is preferably 0.20 pm or more and 1.0 um or less (Experiment examples 1 to 10, 13 to 18 of Table 2, Experiment examples 18 to 21 of Table 3). When the thickness of the undercoat layer is less than 0.2 pm, the adhesion improvement effect is low, and when the thickness is exceeds 1 pm, the ratio of undercoat layer having low hardness is increased and abrasion resistance is reduced.

In the present example having the above-described configuration, the first coating layer has both hardness and toughness without excessively high hardness, and demonstrates good abrasion resistance against stainless steel. Also, seizing resistance can be ensured due to the second coating layer, which has excellent lubricity. Therefore, the abrasion resistance and seizing resistance of a cutting tool against stainless steel (in particular, austenitic stainless steel) is improved, and the occurrence of chipping can be inhibited to the extent possible to ensure longer service life of a cutting tool.

Hence, the present example demonstrates good abrasion resistance and seizing resistance against austenitic stainless steel as well, and is extremely practical in that longer service life of a cutting tool can be realized.

Experiment examples that support the effect of the present example will be described.

An arc-discharge ion-plating device was used as a film formation device, targets having various compositions were mounted in the film formation device as evaporation sources having metal and metalloid components, $N_2$ gas as a reaction gas was introduced into the film formation device, and a predetermined coating was formed on a four-blade square end mill (outside diameter: 6 mm) made of a super hard metal alloy as a film formation substrate. The super hard metal alloy substrate that was used was composed of hard particles having WC as a main component and a binding material having Co as a main component, the average particle diameter of the WC particles being 0.5 pm and the Co content being 10 mass%. The films were formed on the above-described substrate end mill so that the undercoat layer, the first coating layer, and the second coating layer reached various thicknesses.

A cutting test was carried out by using SUS304 as a workpiece, and cutting a side surface under wet machining conditions using water-soluble cutting oil. The test was carried out using an end mill having an outside diameter of 6 mm at a rotating speed of 12,000 $min^{-1}$, a feed speed of 650 mm/min, a cutting distance of 0.3 mm in the diameter direction, and a cutting distance of 2.0 mm in the axial direction. In the machining test for Tables 1 and 2, comparative evaluations were made for a machining time of 60 minutes (initial stage of machining).

In the machining tests of Table 3, the machining test was further extended to 180 minutes and a comparative evaluation was made in order to manifest the effect of improving the adhesion of the hard coating by the provision of an undercoat layer.

In other words, the hard coatings (experiment examples) pertaining to the configuration of the present example, conventional hard coatings, and the hard coatings (comparative examples) outside the range of the present invention were each coated on an end mill using the above-described means, and a cutting test was carried out using the end mills. The test results are shown in Tables 1 to 3.

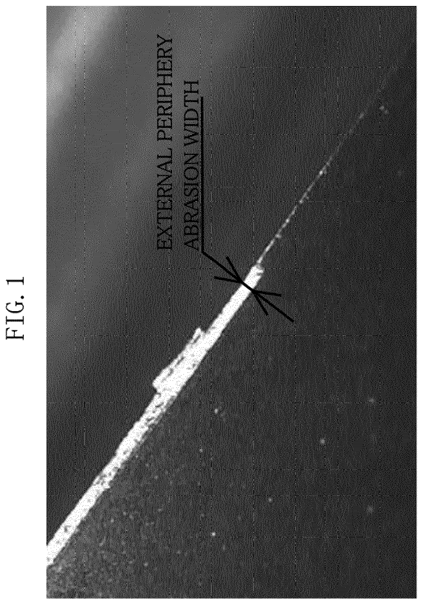

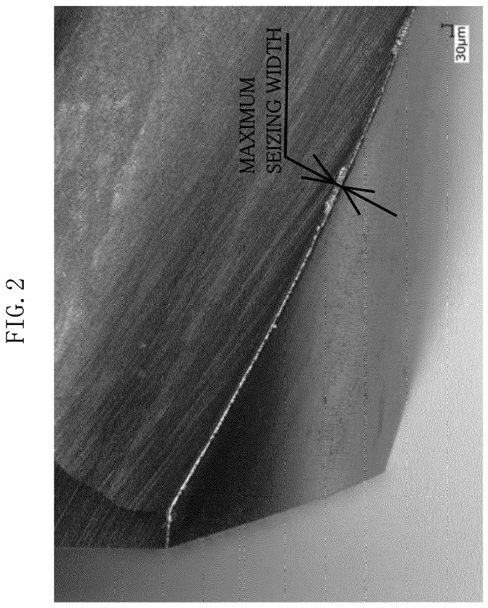

The external periphery abrasion width was obtained by measuring the abrasion width at the external periphery of the blade in a right-angle direction to the blade from the distal end of the end mill at a position 2 mm of cutting distance in the axial direction (see FIG. 1). The maximum seizing width was obtained by measuring the maximum seizing width (rake face side) of the seized material seized to the external peripheral blade in the right-angle direction to the blade from the distal end of the end mill in an area within 2.0 mm of cutting distance in the axial direction (see FIG. 2).

Table 1

| No. | Undercoat layer | | First coating layer | | Second coating layer | | Total thk (T1+T2) ($\mu$m) | Thk ratio (T2/T1) | (Max. intensity peak plane) | (Ext. periph. abras. width) (mm) | Max. seizing width (mm) | Chipping | Assessment | | |
|---|---|---|---|---|---|---|---|---|---|---|---|---|---|---|---|
| | Comp. | Thk ($\mu$m) | Comp. | Thk T1 ($\mu$m) | Comp. | Thk T2 ($\mu$m) | | | | | | | Abrasion resist. | Seizing resist. | Overall determ. |
| Conv. ex. 1 | TiN | 0.3 | $(Al_{50}Cr_{30}V_{10}B_{10})N$ | 3 | - | - | 3 | - | (200) | 0.016 | 0.069 | Yes | ○ | × | △ |
| Conv. ex. 2 | - | - | $(Al_{60}Cr_{32}V_3B_5)N$ | 4 | - | - | 4 | - | (200) | 0.018 | 0.065 | Yes | ○ | × | △ |
| Conv. ex. 3 | - | - | $(Al_{57}Cr_{30}V_3B_{10})N$ | 1.8 | $(Cr_{80}V_{20})N$ | 0.4 | 2.2 | 0.22 | (200) | 0.016 | 0.032 | Yes | ○ | ○ | ○ |
| Conv. ex. 4 | TiN | 0.3 | $(Al_{70}Cr_{30})N$ | 3 | - | - | 3 | - | (200) | 0.022 | 0.069 | No | × | × | × |
| Comp. ex. 1 | TiN | 0.5 | $(Al_{75}Cr_{25})N$ | 3 | - | - | 3 | - | (111) | 0.018 | 0.056 | No | ○ | × | △ |
| Comp. ex. 2 | TiN | 0.3 | $(Al_{65}Cr_{35})N$ | 3 | - | - | 3 | - | (111) | 0.019 | 0.088 | No | ○ | × | △ |
| Comp. ex. 3 | TiN | 0.5 | $(Al_{70}Cr_{30})N$ | 3 | - | - | 3 | - | (111) | 0.018 | 0.081 | No | ○ | × | △ |
| Comp. ex. 4 | TiN | 0.8 | $(Al_{80}Cr_{20})N$ | 3 | - | - | 3 | - | (111) | 0.024 | 0.089 | No | × | × | × |
| Comp. ex. 5 | TiN | 0.3 | $(Al_{50}Cr_{50})N$ | 3 | - | - | 3 | - | (111) | 0.022 | 0.051 | No | × | × | × |
| Comp ex. 6 | TiN | 0.3 | $(Al_{20}Cr_{80})N$ | 3 | - | - | 3 | - | (111) | 0.029 | 0.050 | No | × | × | × |
| Comp ex. 7 | TiN | 0.3 | $(Al_{70}Cr_{30})N$ | 3 | - | - | 3 | - | (200) | 0.022 | 0.050 | No | × | × | × |
| Comp. ex. 8 | TiN | 0.8 | $(Al_{75}Cr_{25})N$ | 3 | - | - | 3 | - | (200) | 0.024 | 0.053 | No | × | × | × |
| Comp. ex. 9 | TiN | 0.3 | $(Al_{65}Cr_{35})N$ | 3 | - | - | 3 | - | (200) | 0.024 | 0.044 | No | × | × | × |

(continued)

| No. | Undercoat layer Comp. | Undercoat layer Thk (μm) | First coating layer Comp. | First coating layer Thk T1 (μm) | Second coating layer Comp. | Second coating layer Thk T2 (μm) | Total thk (T1+T2) (μm) | Thk ratio (T2/T1) | (Max. intensity peak plane) | (Ext. periph. abras. width) (mm) | Max. seizing width (mm) | Chipping | Assessment Abrasion resist. | Assessment Seizing resist. | Assessment Overall determ. |
|---|---|---|---|---|---|---|---|---|---|---|---|---|---|---|---|
| Comp. ex. 10 | TiN | 0.3 | $(Al_{70}Cr_{30})N$ | 3 | $(Cr_{100})N$ | 0.6 | 3.6 | 0.20 | (111) | 0.017 | 0.044 | No | ○ | × | × |
| Comp. ex. 11 | TiN | 0.8 | $(Al_{70}Cr_{30})N$ | 3 | $(Cr_{90}V_{10})N$ | 0.6 | 3.6 | 0.20 | (111) | 0.016 | 0.069 | No | ○ | × | × |
| Comp. ex. 12 | TiN | 0.3 | $(Al_{70}Cr_{30})N$ | 3 | $(Cr_{45}V_{55})N$ | 0.6 | 3.6 | 0.20 | (111) | 0.016 | 0.056 | No | ○ | × | × |
| Comp. ex. 13 | TiN | 0.3 | $(Al_{70}Cr_{30})N$ | 3 | $(Cr_{80}V_{20})N$ | 0.2 | 3.2 | 0.07 | (111) | 0.016 | 0.057 | No | ○ | × | × |
| Comp. ex. 14 | TiN | 0.8 | $(Al_{70}Cr_{30})N$ | 2 | $(Cr_{80}V_{20})N$ | 1.2 | 3.2 | 0.60 | (111) | 0.024 | 0.050 | No | × | × | × |
| Comp. ex. 15 | TiN | 0.3 | $(Al_{70}Cr_{30})N$ | 1 | $(Cr_{80}V_{20})N$ | 1.2 | 2.2 | 1.20 | (111) | 0.030 | 0.060 | No | × | × | × |
| Comp. ex. 16 | TiN | 0.3 | $(Al_{70}Cr_{30})N$ | 0.6 | $(Cr_{80}V_{20})N$ | 0.2 | 0.8 | 0.33 | (111) | 0.024 | 0.033 | No | × | ○ | △ |
| Comp. ex. 17 | TiN | 0.3 | $(Al_{70}Cr_{30})N$ | 5 | $(Cr_{80}V_{20})N$ | 1.8 | 6.8 | 0.36 | (111) | 0.016 | 0.028 | No | ○ | ○ | △ |

Table 2

| No. | Undercoat layer Comp. | Undercoat layer Thk (μm) | First coating layer Comp. | First coating layer Thk T1 (μm) | Second coating layer Comp. | Second coating layer Thk T2 (μm) | Total thk (T1+T2) (μm) | Thk ratio (T2/T1) | (Max. intensity peak plane) | (Ext. periph. abras. width) (mm) | Max. seizing width (mm) | Chipping | Assessment Abrasion resist. | Assessment Seizing resist. | Assessment Overall determ. |
|---|---|---|---|---|---|---|---|---|---|---|---|---|---|---|---|
| Exp ex. 1 | TiN | 0.3 | $(Al_{75}Cr_{25})N$ | 3 | $(Cr_{80}V_{20})N$ | 0.6 | 3.6 | 0.20 | (111) | 0.012 | 0.025 | No | ◎ | ◎ | ◎ |
| Exp ex. 2 | TiN | 0.5 | $(Al_{70}Cr_{30})N$ | 2.8 | $(Cr_{80}V_{20})N$ | 0.6 | 3.4 | 0.21 | (111) | 0.013 | 0.026 | No | ◎ | ◎ | ◎ |
| Exp ex. 3 | TiN | 0.3 | $(Al_{63}Cr_{35})N$ | 3 | $(Cr_{80}V_{20})N$ | 0.6 | 3.6 | 0.20 | (111) | 0.015 | 0.024 | No | ◎ | ◎ | ◎ |
| Exp ex. 4 | TiN | 0.5 | $(Al_{70}Cr_{30})N$ | 3 | $(Cr_{85}V_{15})N$ | 0.6 | 3.6 | 0.20 | (111) | 0.015 | 0.028 | No | ◎ | ◎ | ◎ |
| Exp ex. 5 | TiN | 0.7 | $(Al_{70}Cr_{30})N$ | 2.6 | $(Cr_{75}V_{25})N$ | 0.6 | 3.2 | 0.23 | (111) | 0.015 | 0.028 | No | ◎ | ◎ | ◎ |
| Exp ex. 6 | TiN | 0.5 | $(Al_{70}Cr_{30})N$ | 3 | $(Cr_{65}V_{35})N$ | 0.6 | 3.6 | 0.20 | (111) | 0.019 | 0.030 | No | ○ | ○ | ○ |
| Exp ex. 7 | TiN | 0.3 | $(Al_{70}Cr_{30})N$ | 3 | $(Cr_{50}V_{50})N$ | 0.6 | 3.6 | 0.20 | (111) | 0.018 | 0.038 | No | ○ | ○ | ○ |
| Exp ex. 8 | TiN | 0.5 | $(Al_{70}Cr_{30})N$ | 3.5 | $(Cr_{80}V_{20})N$ | 1.5 | 5 | 0.43 | (111) | 0.012 | 0.026 | No | ◎ | ◎ | ◎ |
| Exp ex. 9 | TiN | 0.3 | $(Al_{70}Cr_{30})N$ | 2 | $(Cr_{80}V_{20})N$ | 1.0 | 3 | 0.50 | (111) | 0.016 | 0.028 | No | ◎ | ◎ | ◎ |
| Exp ex. 10 | TiN | 0.5 | $(Al_{70}Cr_{30})N$ | 2 | $(Cr_{80}V_{20})N$ | 0.2 | 2.2 | 0.10 | (111) | 0.015 | 0.025 | No | ◎ | ◎ | ◎ |
| Exp ex. 11 | - | - | $(Al_{70}Cr_{30})N$ | 3 | $(Cr_{80}V_{20})N$ | 0.6 | 3.6 | 0.20 | (111) | 0.019 | 0.030 | No | ○ | ○ | ○ |
| Exp ex. 12 | - | - | $(Al_{70}Cr_{30})N$ | 3 | $(Cr_{80}V_{20})N$ | 0.6 | 3.6 | 0.20 | (111) | 0.02 | 0.035 | No | ○ | ○ | ○ |
| Exp ex. 13 | TiN | 0.2 | $(Al_{70}Cr_{30})N$ | 3 | $(Cr_{80}V_{20})N$ | 0.6 | 3.6 | 0.20 | (111) | 0.012 | 0.027 | No | ◎ | ◎ | ◎ |

| No. | Undercoat layer | | First coating layer | | Second coating layer | | Total thk (T1+T2) (μm) | Thk ratio (T2/T1) | (Max. intensity peak plane) | (Ext. periph. abras. width) (mm) | Max. seizing width (mm) | Chipping | Assessment | | |
|---|---|---|---|---|---|---|---|---|---|---|---|---|---|---|---|
| | Comp. | Thk (μm) | Comp. | Thk T1 (μm) | Comp. | Thk T2 (μm) | | | | | | | Abrasion resist. | Seizing resist. | Overall determ. |
| Exp ex. 14 | TiN | 0.5 | $(Al_{70}Cr_{30})N$ | 3 | $(Cr_{80}V_{20})N$ | 0.6 | 3.6 | 0.20 | (111) | 0.015 | 0.023 | No | ◎ | ◎ | ◎ |
| Exp ex. 15 | TiN | 1.0 | $(Al_{70}Cr_{30})N$ | 3 | $(Cr_{80}V_{20})N$ | 0.6 | 3.6 | 0.20 | (111) | 0.015 | 0.024 | No | ◎ | ◎ | ◎ |
| Exp ex.16 | TiCN | 0.2 | $(Al_{70}Cr_{30})N$ | 3 | $(Cr_{80}V_{20})N$ | 0.6 | 3.6 | 0.20 | (111) | 0.016 | 0.028 | No | ◎ | ◎ | ◎ |
| Exp ex. 17 | TiCN | 0.5 | $(Al_{70}Cr_{30})N$ | 3 | $(Cr_{80}V_{20})N$ | 0.6 | 3.6 | 0.20 | (111) | 0.012 | 0.024 | No | ○ | ◎ | ◎ |
| Exp ex. 18 | TiCN | 1.0 | $(Al_{70}Cr_{30})N$ | 3 | $(Cr_{80}V_{20})N$ | 0.6 | 3.6 | 0.20 | (111) | 0.017 | 0.028 | No | ◎ | ◎ | ◎ |

Table 3

| No. | Undercoat layer | | First coating layer | | Second coating layer | | Total thk (T1+T2) (μm) | Thk ratio (T2/T1) | (Max. intensity peak plane) | (Ext. periph. abras. width) (mm) | Max. seizing width (mm) | Chipping | Assessment | Remarks |
|---|---|---|---|---|---|---|---|---|---|---|---|---|---|---|
| | Comp. | Thk (μm) | Comp. | Thk T1 (μm) | Comp. | Thk T2 (μm) | | | | | | | Adhesion | |
| Exp ex. 19 | TiN | 0.3 | $(Al_{70}Cr_{30})N$ | 3 | $(Cr_{80}V_{20})N$ | 1 | 4 | 0.33 | (111) | 0.025 | 0.028 | No | ◎ | |
| Exp ex. 20 | TiN | 0.5 | $(Al_{70}Cr_{30})N$ | 2.5 | $(Cr_{80}V_{20})N$ | 0.4 | 2.9 | 0.16 | (111) | 0.030 | 0.029 | No | ◎ | |
| Exp ex. 21 | TiN | 0.3 | $(Al_{70}Cr_{30})N$ | 4 | $(Cr_{80}V_{20})N$ | 0.4 | 4.4 | 0.10 | (111) | 0.035 | 0.026 | No | ◎ | |
| Exp ex. 22 | TiN | 0.2 | $(Al_{70}Cr_{30})N$ | 3.1 | $(Cr_{80}V_{20})N$ | 1 | 4.1 | 0.32 | (111) | 0.033 | 0.030 | No | ◎ | |
| Exp ex. 23 | TiN | 0.5 | $(Al_{70}Cr_{30})N$ | 3.3 | $(Cr_{80}V_{20})N$ | 0.8 | 4.1 | 0.24 | (111) | 0.035 | 0.030 | No | ◎ | |
| Exp ex. 24 | TiN | 1.0 | $(Al_{70}Cr_{30})N$ | 3 | $(Cr_{80}V_{20})N$ | 0.6 | 3.6 | 0.20 | (111) | 0.040 | 0.027 | No | ◎ | |
| Exp ex.25 | TiCN | 0.2 | $(Al_{70}Cr_{30})N$ | 3.1 | $(Cr_{80}V_{20})N$ | 0.6 | 3.7 | 0.19 | (111) | 0.039 | 0.030 | No | ◎ | |
| Exp ex.26 | TiCN | 0.5 | $(Al_{70}Cr_{30})N$ | 3.3 | $(Cr_{80}V_{20})N$ | 0.8 | 4.1 | 0.24 | (111) | 0.028 | 0.027 | No | ◎ | |
| Exp ex.27 | TiCN | 1.0 | $(Al_{70}Cr_{30})N$ | 3 | $(Cr_{80}V_{20})N$ | 0.6 | 3.6 | 0.20 | (111) | 0.035 | 0.028 | No | ◎ | |
| Exp ex. 28 | - | - | $(Al_{70}Cr_{30})N$ | 4 | $(Cr_{80}V_{20})N$ | 0.8 | 4.8 | 0.20 | (111) | 0.044 | 0.044 | No | × | Rake face peeling |
| Exp ex. 29 | - | - | $(Al_{70}Cr_{30})N$ | 3 | $(Cr_{80}V_{20})N$ | 1 | 4 | 0.33 | (111) | 0.045 | 0.045 | No | × | Rake face peeling |
| Comp. ex. 18 | TiN | 0.1 | $(Al_{70}Cr_{30})N$ | 3 | $(Cr_{80}V_{20})N$ | 0.8 | 3.8 | 0.27 | (111) | 0.063 | 0.045 | No | × | Rake face peeling |
| Comp. ex. 19 | TiN | 1.2 | $(Al_{70}Cr_{30})N$ | 3 | $(Cr_{80}V_{20})N$ | 1 | 4 | 0.33 | (111) | 0.071 | 0.055 | No | Δ | Abrasion resistance × |
| Comp. ex. 20 | TiCN | 0.1 | $(Al_{70}Cr_{30})N$ | 3 | $(Cr_{80}V_{20})N$ | 1.2 | 4.2 | 0.40 | (111) | 0.068 | 0.065 | No | × | Rake face peeling |
| Comp. ex. 21 | TiCN | 1.2 | $(Al_{70}Cr_{30})N$ | 3 | $(Cr_{80}V_{20})N$ | 1.4 | 4.4 | 0.47 | (111) | 0.069 | 0.070 | No | Δ | Abrasion resistance × |

The experiment examples are observed from Tables 1 and 2 to have reduced external periphery abrasion width of the end mill and improved seizing resistance in comparison with the conventional examples and comparative examples.

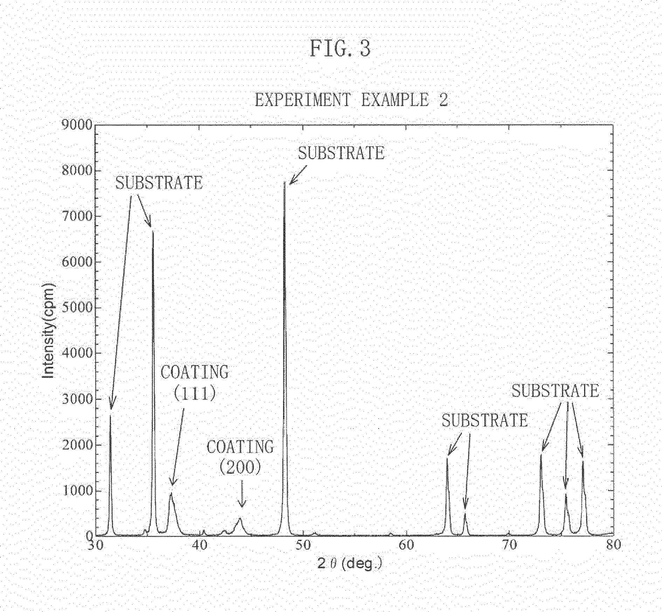

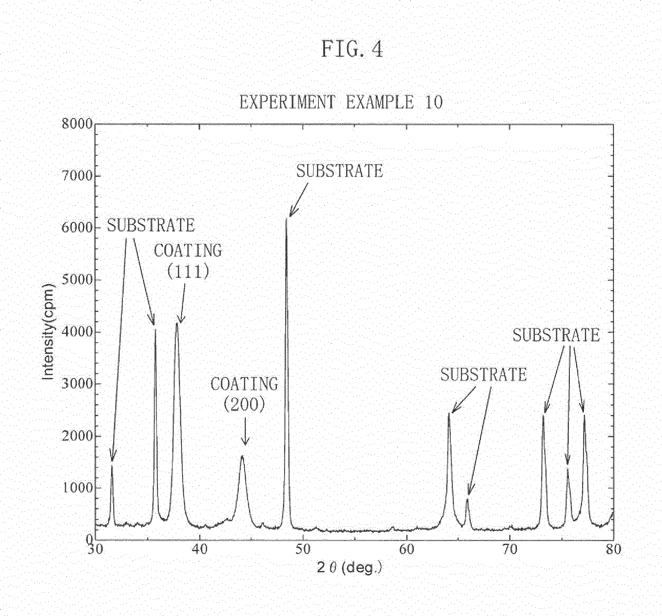

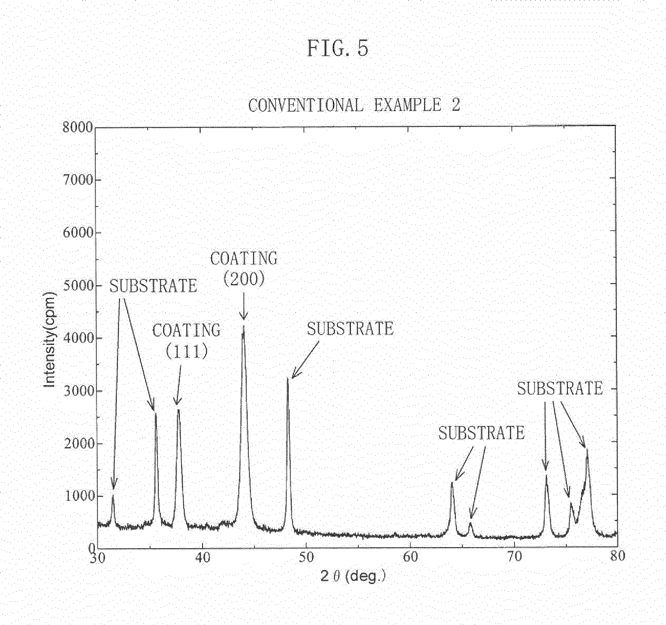

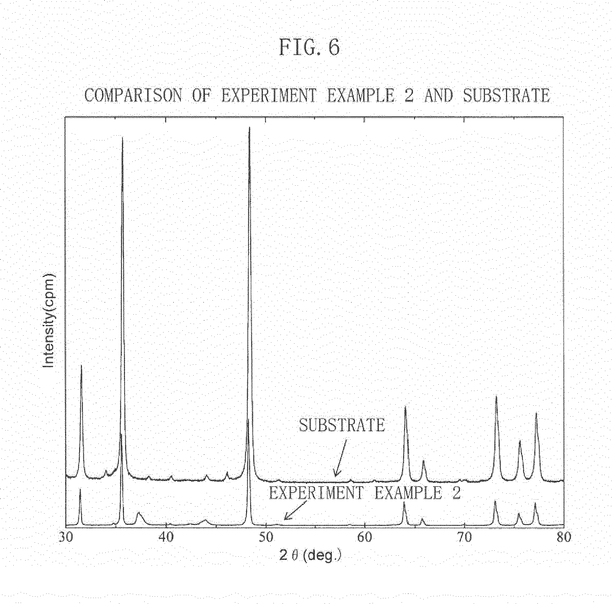

FIGS. 3 and 4 are X-ray diffraction patterns of experiment examples 2 and 10, respectively, of Table 2. It can be confirmed that the diffraction intensity of the (111) plane is greater than the diffraction intensity of the (200) plane. FIG. 5 is an X-ray diffraction pattern of conventional example 2, and FIG. 6 is a comparative view of X-ray diffraction patterns of experiment example 2 and the substrate alone.

When film is formed using an arc-discharge ion-plating device, the crystal alignment of the coating can be controlled using film formation conditions, regardless of targets having identical compositions, and in the present example, excellent abrasion resistance is realized by ensuring that the diffraction intensity of the (111) plane having a NaCl crystal structure is greater than the diffraction intensity of the (200) plane. In particular, the ratio between the diffraction intensity of the (111) plane and the diffraction intensity of the (200) plane is preferably $I(111)/I(200) \geq 1.5$. Although not shown in the table, it had been confirmed that $I(111)/I(200) \geq 1.5$ in each of the experiment examples.

It was also confirmed from Table 3 that adhesion is improved by the provision of an undercoat layer, and that even greater abrasion resistance and seizing resistance are demonstrated.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

**Claims**

1. A cutting tool for stainless steels, the cutting tool having a hard coating that is formed on a substrate, the hard coating comprising:

   a first coating layer consisting of

   i) $Al_{(100-x)}Cr_{(x)}$, where $25 \leq X \leq 35$,
   ii) N as a non-metal element, and
   iii) inevitable impurities; and

   a second coating layer consisting of

   i) $Cr_{(100-\alpha)}V_{(\alpha)}$, where $15 \leq \alpha \leq 50$,
   ii) N as a non-metal element, and
   iii) inevitable impurities,

   the first coating layer being coated with the second coating layer, and
   the second coating layer forming the topmost layer, wherein
   the ratio of the thickness T1 of the first coating layer and the thickness T2 of the second coating layer is $0.1 \leq T2/T1 \leq 0.5$,
   and the sum of the thickness T1 and the thickness T2 is 2.0 pm or more and 5.0 pm or less.

2. The cutting tool according to claim 1, the hard coating **characterized in that** the term $\alpha$ is 15 or more and 25 or less.

3. The cutting tool according to claim 1 or 2, the hard coating **characterized in that** an undercoat layer is provided between the substrate and the first coating layer, the undercoat layer comprises a Ti nitride or carbonitride, and the thickness of the undercoat layer is 0.20 pm or more and 1.0 pm or less.

**Patentansprüche**

1. Schneidwerkzeug für rostfreie Stähle, wobei das Schneidwerkzeug eine harte Beschichtung aufweist, die auf einem Substrat ausgebildet ist, wobei die harte Beschichtung aufweist:

   eine erste Beschichtungsschicht bestehend aus

i) $Al_{(100-x)}Cr_{(x)}$, wobei $25 \leq X \leq 35$,
ii) N als ein Nicht-Metallelement und
iii) unvermeidbare Verunreinigungen; und

eine zweite Beschichtungsschicht bestehend aus

i) $Cr_{(100-\alpha)}V_{(\alpha)}$, wobei $15 \leq \alpha \leq 50$,
ii) N als ein Nicht-Metallelement und
iii) unvermeidbare Verunreinigungen,

wobei die erste Beschichtungsschicht mit der zweiten Beschichtungsschicht beschichtet ist und die zweite Beschichtungsschicht die oberste Schicht bildet, wobei das Verhältnis der Dicke T1 der ersten Beschichtungsschicht und der Dicke T2 der zweiten Beschichtungsschicht $0,1 \leq T2/T1 \leq 0,5$ ist und die Summe aus der Dicke T1 und der Dicke T2 2,0 $\mu$m oder mehr und 5,0 $\mu$m oder weniger beträgt.

2. Schneidwerkzeug nach Anspruch 1, bei dem die harte Beschichtung **dadurch gekennzeichnet ist, dass** der Ausdruck $\alpha$ 15 oder mehr und 25 oder weniger beträgt.

3. Schneidwerkzeug nach Anspruch 1 oder 2, bei dem die harte Beschichtung **dadurch gekennzeichnet ist, dass** eine Grundschicht zwischen dem Substrat und der ersten Beschichtungsschicht vorgesehen ist, wobei die Grundschicht ein Ti-Nitrid oder ein Ti-Carbonitrid aufweist und die Dicke der Grundschicht 0,20 $\mu$m oder mehr und 1,0 $\mu$m oder weniger beträgt.

**Revendications**

1. Outil de coupe pour les aciers inoxydables, l'outil de coupe ayant un revêtement dur qui est formé sur un substrat, le revêtement dur comprenant :

une première couche de revêtement constituée de

i) $Al_{(100-x)}Cr_{(x)}$, où $25 \leq X \leq 35$,
ii) N comme élément non métallique, et
iii) les impuretés inévitables ; et

une seconde couche de revêtement constituée de

i) $Cr_{(100-\alpha)}V_{(\alpha)}$, où $15 \leq \alpha \leq 50$,
ii) N comme élément non métallique, et
iii) les impuretés inévitables,

la première couche de revêtement est recouverte de la seconde couche de revêtement, et la seconde couche de revêtement formant la couche supérieure, dans lequel le rapport entre l'épaisseur T1 de la première couche de revêtement et l'épaisseur T2 de la seconde couche de revêtement est de $0,1 \leq T2/T1 \leq 0,5$, et la somme de l'épaisseur T1 et de l'épaisseur T2 est de 2,0 $\mu$m ou plus et de 5,0 $\mu$m ou moins.

2. Outil de coupe selon la revendication 1, le revêtement dur **caractérisé en ce que** le terme $\alpha$ est de 15 ou plus et de 25 ou moins.

3. Outil de coupe selon la revendication 1 ou 2, le revêtement dur **caractérisé en ce qu'**une couche de sous-couche est pourvue entre le substrat et la première couche de revêtement, la couche de sous-couche comprend un nitrure de Ti ou un carbonitrure, et l'épaisseur de la couche de sous-couche est de 0,20 $\mu$m ou plus et de 1,0 $\mu$m ou moins.

FIG. 1

EXTERNAL PERIPHERY
ABRASION WIDTH

FIG. 2

MAXIMUM SEIZING WIDTH

30μm

FIG. 3

EXPERIMENT EXAMPLE 2

# FIG. 4

EXPERIMENT EXAMPLE 10

# FIG. 5

### CONVENTIONAL EXAMPLE 2

FIG. 6

COMPARISON OF EXPERIMENT EXAMPLE 2 AND SUBSTRATE

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H1025566 A
- JP 4459936 B
- JP 2003136305 A
- JP 2003136306 A
- JP 2003136307 A